# EUROPEAN PATENT SPECIFICATION

(11) **EP 0 414 426 B1**
(45) Date of publication and mention of the grant of the patent: **29.03.1995**
(21) Application number: 90308873.0
(22) Date of filing: 13.08.1990
(51) Int. Cl.: H03M 1/12

(54) **Superconducting analog-to-digital converter with grounded four-junction squid bidirectional counter**
Supraleitender Analog-zu-Digital-Konverter mit einem geerdeten Vier-Übergang-Squid-Zweirichtungszähler
Convertisseur supraconducteur analogue-digital avec compteur bidirectionnel d'interféromètre à 4 jonctions communes

(30) Priority: 24.08.1989 US 397923; 24.08.1989 US 397932
(43) Date of publication of application: 27.02.1991
(60) Divisional application: 94106184.8
(73) Proprietor: TRW INC., Cleveland Ohio 44124 (US)
(72) Inventor: Lee, Gregory S., No.7 West Los Angeles, CA 90025 (US)
(74) Representative: Crawford, Andrew Birkby

(56) References cited:
- EP-A- 0 119 586
- EP-A- 0 222 470
- EP-A- 0 304 894
- EP-A- 0 320 100
- US-A- 4 646 060
- US-A- 4 879 488

## Description

### BACKGROUND OF THE INVENTION

This invention relates generally to analog-to-digital converters and, more particularly, to high-speed, high-resolution analog-to-digital converters employing superconducting Josephson junctions.

High-performance analog-to-digital (A/D) converters are required in a variety of commercial and military electronic devices. Two of the more important measures of an A/D converter's performance are its speed, as measured by the number of samples converted per second, and resolution, as measured by the smallest increment of change that can be detected in an analog signal. Superconducting technology is particularly well suited to performing high-speed, high-resolution A/D conversion because Josephson junctions, which are the basic switching elements utilized in superconducting electronic devices, possess a unique combination of speed, sensitivity, and periodic response characteristics.

The Josephson junction is a simple bistable switching device having a very thin insulating layer sandwiched between two superconducting electrodes. When current supplied to the Josephson junction is increased above the critical current of the junction, the device is switched from a superconducting zero-voltage state to a resistive voltage state. The resistive voltage state, in which the voltage drop across the device is equal to the energy gap of the superconductor material, is switched off by reducing the current supplied to the junction to about zero. Because this switching operation can occur in as little as a few picoseconds, the Josephson junction is truly a high speed switching device. In a superconducting A/D converter, one or more of the Josephson junctions are combined with one or more inductive loads to form a logic circuit called a SQUID, or Superconducting Quantum Interference Device.

The characteristics of the SQUID that provide the basis for superconducting A/D conversion can best be explained with reference to a single-junction SQUID.The single-junction SQUID, which is simply a Josephson junction connected across an inductance to form a superconducting loop, exhibits a periodic and multivalued relationship between the current injected into the inductance and the magnetic flux in the loop. The magnetic flux in the loop increases by a small quantum whenever the current increases by a small and precisely repeatable increment. This quantum of flux gives rise to a small but measurable voltage pulse across the junction. When the current is decreased by a like increment, the magnetic flux in the loop decreases by the small quantum, and a corresponding voltage pulse of the opposite polarity is produced across the junction.

In order to convert a signal from analog to digital form using the single-junction SQUID, the analog signal is introduced into the SQUID as a varying current. Each time the current increases or decreases by a predetermined amount, a measurable voltage pulse is generated across the junction. In this manner, the SQUID functions as a quantizer, with the resultant pulses being detected and counted in one or more binary counters. The principle advantages of this superconducting counting A/D converter are its near perfect linearity and its high sensitivity and speed. The current increment or decrement, which determines the resolution of the device, can be made extremely small. This is because a single flux quantum is only 2.07 x 10⁻¹⁵ weber and the current increment or decrement is the flux quantum divided by the value of the inductance (measured in henries).

U.S. Patent No. 4,646,060 to Phillips et al. discloses a superconducting counting A/D converter having a double-junction SQUID quantizer and a bidirectional binary counter comprised of n stages of double-junction SQUID flip-flops, where n is the number of bits of accuracy of the counter. The quantizer generates up-count and down-count voltage pulses of the same polarity on two different output lines, rather than voltage pulses of the opposite polarity on the same output line, as in the single-junction SQUID. The bidirectional binary counter algebraically counts the voltage pulses, increasing the binary count when up-count pulses are received and decreasing the binary count when down-count pulses are received. Superconducting logic circuitry, which includes numerous AND and OR gates, provides the carry and borrow functions of the counter.

Although the Phillips et al. A/D converter has certain advantages, it also has several disadvantages. One disadvantage is that the additional logic circuitry reduces the speed and increases the device count of the A/D converter. An increased device count reduces the reliability of the A/D converter and also increases its cost. Accordingly, there has been a need for a superconducting analog-to-digital converter that does not require this additional logic circuitry. The present invention fulfills this need.

### SUMMARY OF THE INVENTION

The present invention resides in a high-speed, high-resolution superconducting counting A/D converter providing greatly increased conversion speeds with a low device count. The superconducting counting A/D converter includes a double-junction SQUID quantizer and a bidirectional binary counter having n stages of four-junction SQUID flip-flops that may be either floating or grounded, where n is the number of bits of accuracy of the counter. The quantizer continuously tracks an analog signal, generating up-count and down-count voltage pulses of the same polarity on two different output lines for increasing and decreasing values of the analog current, respectively. The bidirectional binary counter algebraically counts the voltage pulses, increasing the binary count when up-count pulses are received and decreasing the binary count when down-count pulses are received.

The quantizer includes two Josephson junctions and a center-tapped inductance connected together to form a superconducting loop. A constant gate current is injected into the center-tap terminal of the inductance, while the analog signal is transformer-coupled through a winding to the inductance. The bidirectional binary counter includes n stages of the floating four-junction SQUID flip-flops connected together in a cascade arrangement from the least significant bit (LSB) to the most significant bit (MSB). Each floating four-junction SQUID flip-flop includes four Josephson junctions and two center-tapped inductances connected together to form a superconducting loop.

The four-junction SQUID flip-flop is a bistable logic circuit in which the direction of the circulating current determines the state of the circuit. A "O" bit is represented by a counterclockwise circulating supercurrent and a "I" bit is represented by a clockwise circulating supercurrent When an up-count or down-count pulse is applied to the SQUID flip-flop, the current through one of the Josephson junctions is raised momentarily above the critical current of the junction. This causes the Josephson junction to generate a voltage pulse, thereby reversing the direction of the circulating current. Subsequent pulses applied to the SQUID flip-flop cause the flip-flop to toggle or reverse state. In this manner, an up-count pulse will ripple from flip-flop to flip-flop, changing the binary state of each stage and generating a carry pulse if the initial state of the stage is a "1." A down-count pulse will also ripple from flip-flop to flip-flop, changing the binary state of each stage and generating a borrow pulse if the initial state of the stage is a "0."

In an alternative embodiment of the high-speed high-resolution superconducting counting A/D converter of the present invention, the quantizer is a single-junction SQUID quantizer. The single-junction quantizer generates up-count and down-count voltage pulses of the opposite polarity on a single output line for positive and negative values of an analog voltage, respectively. The quantizer digitizes an analog voltage, rather than an analog current, using the alternating current effect of Josephson junctions. When a voltage is applied to a Josephson junction, an alternating current is generated across the junction. Because the frequency of the current is dependent on the magnitude of the voltage, the average voltage during the sampling interval can be digitized by counting the frequency of the alternating current over that time interval.

In another alternative embodiment of the high speed, high-resolution superconducting counting A/D converter of the present invention, the SQUID flip-flops are grounded three-junction SQUID flip-flops. Each grounded three-junction SQUID flip-flop includes two inductances and three Josephson junctions. Two of the Josephson junctions are similar to the two Josephson junctions in the four-junction SQUID flip-flop and the third Josephson junction replaces the other two Josephson junctions by pulsing either positively or negatively. In still another alternative embodiment of the high-speed superconducting counting A/D converter of the present invention, the quantizer and the LSB four-junction SQUID flip-flop are combined to provide a four-junction SQUID quantizer having an additional bit of sensitivity.

The high-speed, high-resolution superconducting counting A/D converter of the present invention may be used with means for reading the contents of the counter at the end of each sampling interval. One technique for reading the contents of the counter is to utilize a toggling quantizer and two bidirectional binary counters. The quantizer toggles between the two counters at the end of each sampling interval so that one counter can be read while the other counter is counting, and vice versa. An adder combines the outputs of the two counters. Another technique for reading the contents of the binary counter is to utilize a variable-hysteresis quantizer. The variable-hysteresis quantizer inhibits the generation of voltage pulses during the read period, allowing the counter to be read without missing any changes in the analog signal.

The A/D converter of the present invention has many advantages, including very fast A/D conversion speeds and a low device count. These advantages result from the ability of the four-junction SQUID flip-flops to control both the binary states of the stages of the counter and the bidirectional transitions and propagations of the counter. The gates that would normally process this logic cannot operate at the required speeds. Therefore, eliminating the logic gates results in an extremely fast counter which can count up or down at speeds greater than 1 count every 10 picoseconds, or a counting rate of 100 GHz. Eliminating the logic gates also reduces the device count, which greatly enhances reliability and reduces power consumption and cost.

It will be appreciated from the foregoing that the present invention represents a significant advance in the field of superconducting analog-to-digital converters. Other features and advantages of the present invention will become apparent from the following more detailed description, taken in conjunction with the accompanying drawings, which illustrate, by way of example, the principles of the invention.

### BRIEF DESCRIPTION OF THE DRAWINGS

Figure 1 is a circuit diagram of a single-junction SQUID device;
Figure 2 is a graph of the magnetic flux as a function of injected current for the single-junction SQUID;
Figure 3A is a circuit diagram of a high-speed, high-resolution superconducting A/D converter with floating four-junction SQUID;
Figure 3B is a circuit diagram of a high-speed,high resolution superconducting A/D converter with grounded four-junction SQUID;
Figure 4 is a circuit diagram of a single-junction SQUID quantizer;
Figure 5 is a circuit diagram of a toggling quantizer and two bidirectional counters;
Figure 6 is a diagram of the current flowing through the toggling quantizer as a function of time;
Figure 7 is a circuit diagram of a variable-hysteresis quantizer;
Figure 8 is a diagram of the hysteresis of the variable-hysteresis quantizer as a function of time;
Figure 9 is a diagram of the voltage pulses generated by the variable-hysteresis quantizer as a function of time.
Figure 10 is a circuit diagram of a junction SQUID flip-flop; and
Figure 11 is a circuit diagram of a four-junction SQUID quantizer.

### DETAILED DESCRIPTION OF THE PREFERRED EMBODIMENTS

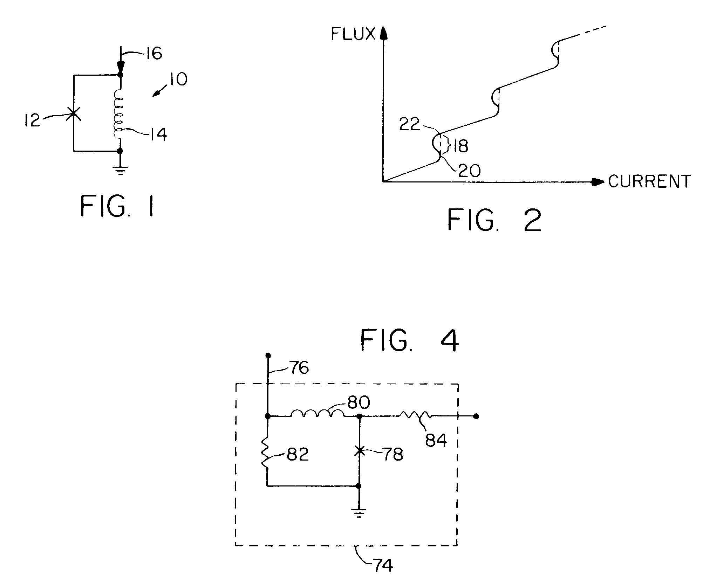

Figure 1 illustrates a single-junction SQUID 10 in which a Josephson junction 12 is connected across an inductance 14 to form a superconducting loop. One terminal of the inductance 14 is connected to a current source, indicated at 16, and the other terminal is connected to ground. Figure 2 is a simplified representation of the relationship between the injected current and the magnetic flux in the loop. As the current increases, the magnetic flux also increases, until a multi-valued region of the curve is reached, as indicated at 18. When a current-reversal point 20 is reached, a further increase in the current causes the magnetic flux to jump to a higher level of the multi-valued region, as indicated at 22. This sudden flux increment results in a small but measurable voltage pulse across the Josephson junction 12.

The curve of Figure 2 is perfectly periodic in that the current increments between successive peaks in the curve are uniform, as are the magnetic flux increments that are generated as a result of the current increments. When the current through the circuit falls, the magnetic flux in the loop is reduced, and corresponding voltage pulses of the opposite polarity are generated across the Josephson junction 12. These characteristics of the SQUID are the basis for A/D conversion using superconducting devices.

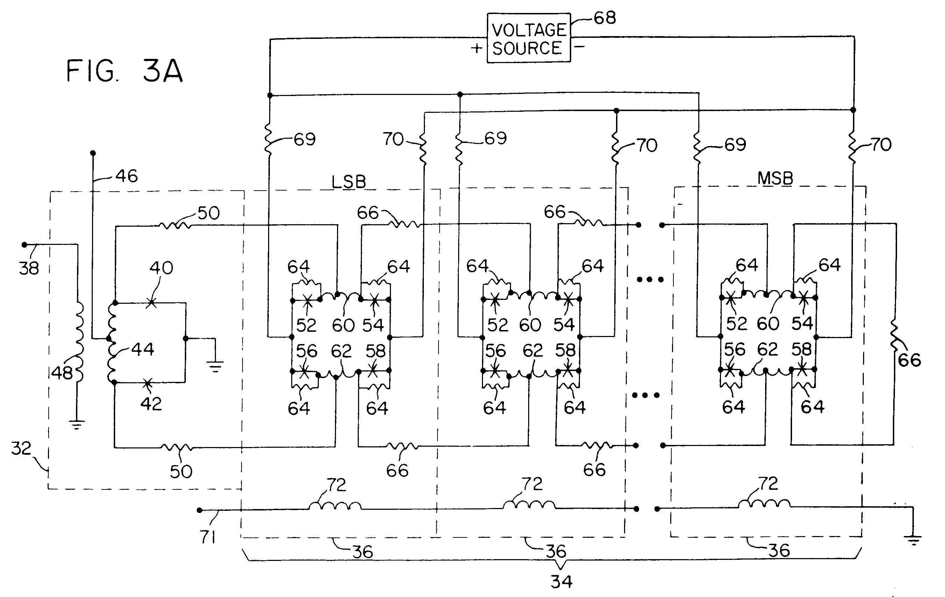

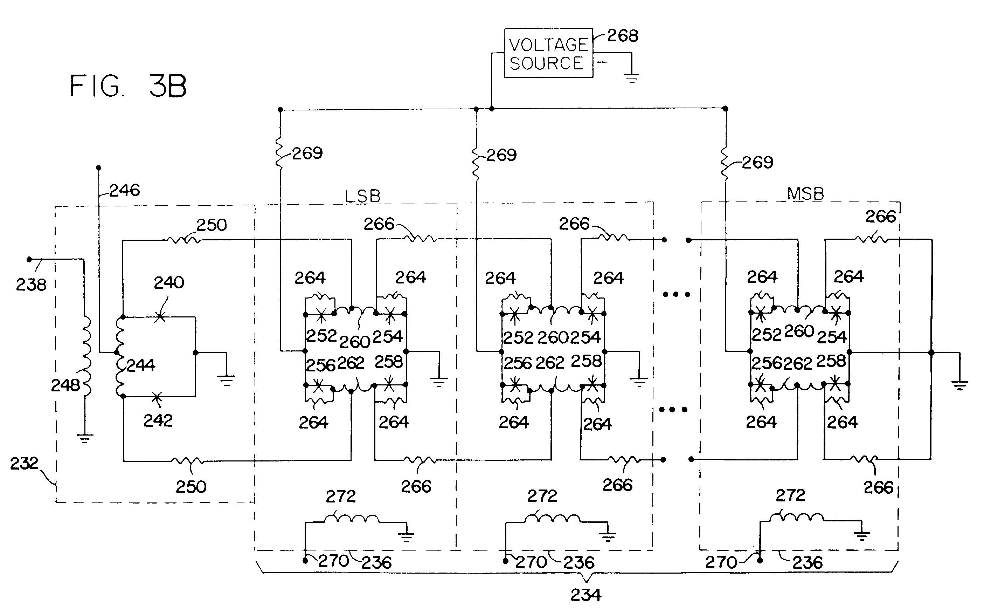

In the following description of Figures of 3A and 3B the same reference numerals identify like circuit elements. It will be appreciated that the circuits in Figures 3A and 3B are similar with the exception of the floating or grounded connection. Figures 3A and 3B illustrate a high-speed, high resolution superconducting counting A/D converter according to the present invention with Figure 3A representing the bidirectional counter 34 having n stages of floating four-junction SQUID flip-flops 36 and in Figure 3B the four-junction SQUID flip-flops 236 are grounded. Figure 3A illustrates a high-speed, high-resolution superconducting counting A/D converter according to the present invention. The superconducting counting A/D converter includes a double-junction SQUID quantizer 32 and a bidirectional binary counter 34 having n stages of floating four-junction SQUID flip-flops 36, where n is the number of bits of accuracy of the counter. In Figure 3B the A/D converter includes a double junction SQUID quantizer 232 and a bidirectional binary counter 234 having n states of grounded four-junction SQUID flip-flops 236.. The quantizer 232 continuously tracks an analog signal, on line 238, generating up-count and down-count voltage pulses of the same polarity on two different output lines for increasing and decreasing values of the analog current, respectively. The bidirectional binary counter 34 (Fig 3A) and 234 (Fig. 3B) algebraically counts the voltage pulses, increasing the binary count when up-count pulses are received and decreasing the binary count when down-count pulses are received.

Referring to Fig. 3A,the quantizer 32 includes two Josephson junctions 40, 42 and a center-tapped inductance 44 connected together to form a superconducting loop. One terminal of each of the Josephson junctions 40, 42 is connected to a different end terminal of the inductance 44 and the other terminal of each of the Josephson junctions 40, 42 is connected to ground. A constant gate current, on line 46, is injected into the center-tap terminal of the inductance 44. The analog signal on line 38 is transformer-coupled through a winding 48 to the inductance 44. Alternatively, the analog signal on line 38 may be directly coupled into the inductance 44. Positive incremental changes in the analog current result in the generation of up-count voltage pulses across Josephson junction 40 and negative incremental changes in the analog current result in the generation of down-count voltage pulses across Josephson junction 42. These up-count and down-count signals are output to the binary counter 34 from the terminals between the inductance 44 and the Josephson junctions 40, 42, respectively, and are each applied to the counter through a resistor 50.

The bidirectional binary counter 34 includes n stages of the floating four-junction SQUID flip-flops 36 connected together in a cascade arrangement from the least significant bit (LSB) to the most significant bit (MSB). Each floating four-junction SQUID flip-flop 36 includes four Josephson junctions 52, 54, 56, 58 and two center-tapped inductances 60, 62 connected together to form a superconducting loop. One terminal of each of the Josephson junctions 52, 54 is connected to a different end terminal of inductance 60 and one terminal of each of the Josephson junctions 56, 58 is connected to a different end terminal of inductance 62. The other terminals of Josephson junctions 52, 56 are connected together and the other terminals 5 of Josephson junctions 54, 58 are connected together. Each of the Josephson junctions 52, 54, 56, 58 also has a shunt resistor 64 connected across its terminals.

The center-tap terminal of inductance 60 receives the carry signal from the preceding four-junction SQUID flip-flop 36 and 36′, or the up-count signal from the quantizer 32 if the four-junction SQUID flip-flop is the LSB flip-flop, and the center-tap terminal of inductance 62 receives the down-count or borrow signal. The carry and borrow signals are output to the succeeding four-junction SQUID flip-flop 36 from the terminal between Josephson junction 54 and inductance 60 and from the terminal between Josephson junction. 58 and inductance 62, respectively, and are each applied to the succeeding SQUID flip-flop through a resistor 66.

A constant gate current is supplied to each four-junction SQUID flip-flop 36 by applying an ungrounded constant voltage source 68 ungrounded to resistors 69 (Figure 3A). The constant gate current flows through each SQUID flip-flop from the terminal between Josephson junctions 52, 56 to the terminal between Josephson junctions 54, 58, where it is returned to the constant voltage source 68 through resistors 70. Because the voltage source 68 and the four-junction SQUID flip-flops 36 are ungrounded, the SQUID flip-flops operate in a floating mode. This allows all four Josephson junctions to be identical, providing a symmetrical SQUID flip-flop. A flux bias of F_{O}/2 , where F_{O} is a flux quantum h/2e = 2.07 x 10⁻¹⁵ weber, is generated in each SQUID flip-flop by a flux bias line 71 and inductances 72. Alternatively, the flux bias can be applied to the SQUID flip-flops by individual flux bias lines rather than by the single flux bias line 71. The flux bias induces a flux bias current in each SQUID flip-flop. The Josephson junctions 52, 54, 56, 58 are resistively shunted so that the SQUID flip-flops 36 operate in a nonlatching mode, which allows the SQUID flip-flops to operate at much faster speeds than when operated in a latching mode.

Each four-junction SQUID flip-flop 36 (Fig. 3A) is a bistable logic circuit in which the direction of the circulating current determines the state of the circuit. A "O" bit is represented by a counterclockwise circulating supercurrent and a "l" bit is represented by a clockwise circulating supercurrent. When an up-count/carry pulse or a down-count/borrow pulse is applied to the SQUID flip-flop, the current through one of the Josephson junctions is raised momentarily above the critical current of the junction. This causes the Josephson junction to generate a voltage pulse, thereby reversing the direction of the circulating current. Subsequent pulses applied to the SQUID flip-flop cause the flip-flop to toggle or reverse state. In this manner, an up-count or carry signal will ripple from flip-flop to flip-flop, changing the binary state of each stage and generating a further carry signal if the initial state of the stage is a "1." A down-count or borrow signal will also ripple from flip-flop to flip-flop, changing the binary state of each stage and generating a further borrow signal if the initial state of the stage is a "0."

Referring further to Figure 3A there are four possible transitions for each of the SQUID flip-flops, 36, from a "0" up to a "1," from a "O" down to a "1," from a "1" up to a "0," and from a "l" down to a "0." When a SQUID flip-flop is indicating a "0," an up-count or carry signal causes Josephson junction 56, while a down-count or borrow signal causes Josephson junction 58, to pulse and output a borrow signal to the suceeding SQUID flip-flop. When a SQUID flip-flop is indicating a "l", an 5 up-count or carry signal causes Josephson junction 54, to pulse and output a carry signal to the suceeding SQUID flip-flop, while a down-count or borrow signal causes Josephson junction 52 to pulse. Accordingly, Josephson junction 54 are the add-with-carry junction, Josephson junction 56 are the add-without-carry junction, Josephson junction 58 are the subtract-with borrow junction, and Josephson junction 52 are the subtract-without-borrow junction.

Looking at each of the transitions in Fig. 3A in more detail, when a bit is indicating a "0," the flux bias current and the gate current combine positively in Josephson junctions 56, 58 and , and negatively in Josephson junctions 52,54.Accordingly, Josephson junctions 56 and 58,support relatively large current flows which will allow them to pulse due to a carry or borrow signal. An up-count or carry signal supplies current to the loop which combines positively with the current through Josephson junction 56 and negatively with the current through Josephson junction 58. Therefore, the current through Josephson junction 56 will exceed its critical current, causing the junction to generate a voltage pulse. The circulation state of the SQUID flip-flop will change to a clock-wise direction, indicating a "1," and no carry or borrow signal will be propagated to the next bit.

A down-count or borrow signal supplies current to the loop which combines positively with the current through Josephson junction 58 and negatively with the current through Josephson junction 56. Therefore, the current through Josephson junction 58 will exceed its critical current, causing the junction to generate a voltage pulse. The circulation state of the SQUID flip-flop will change to a clockwise direction, and a borrow signal will be propagated to the next bit.

When a bit is indicating a "1," the flux bias current and the gate current combine positively in Josephson junctions 52, 54 and negatively in Josephson junctions 56, 58. Accordingly, Josephson junctions 52, and 54 support relatively large current flows which will allow them to pulse due to a carry or borrow signal. An up-count or carry signal supplies current to the loop which combines positively with the current through Josephson junction 54 and negatively with the current through Josephson junction 52. Therefore, the current through Josephson junction 54 will exceed its critical current, causing the junction to generate a voltage pulse. The circulation state of the SQUID flip-flop will change to a counterclockwise direction, indicating a "0," and a carry signal will be propagated to the next bit.

A down-count or borrow signal supplies current to the loop which combines positively with the current through Josephson junction 52 and negatively with the current through Josephson junction 54. Therefore, the current through Josephson junction 52 will exceed its critical current, causing the junction to generate a voltage pulse. The circulation state of the SQUID flip-flop will change to a counterclockwise direction, and no carry or borrow signal will be propagated to the next bit.

In the following description of Figure 3B it will be appreciated that with the exception of the Josephson junctions 236 being electrically grounded the operation is similar to the circuit in Figure 3A. Referring further to Figure 3B, a constant gate current is supplied to each four-junction SQUID flip-flop 236 by applying a grounded constant voltage source 268 to resistors 269. The constant gate current flows through each SQUID flip-flop from the terminal between Josephson junctions 252, 256 to the terminal between Josephson functions 254, 258, where it is grounded. Because the voltage source 268 and the four-junction SQUID flip-flops 236 are grounded, the critical current of Josephson junctions 252, 256 should be about 30% less than that of Josephson junctions 254, 258.

A flux bias of F_{O}/2, where F_{O} is a flux quantum h/2e = 2.07 x 10⁻¹⁵ weber, is generated in each SQUID flip-flop by individual flux bias lines 270 and inductances 272. Alternatively, the flux bias can be applied to the SQUID flip-flops by a single flux bias line rather than by individual flux bias lines. The flux bias induces a flux bias current in each SQUID flip-flop. The Josephson junctions 252, 254, 256, 258 are resistively shunted so that the SQUID flip-flops 236 operate in a nonlatching mode, which allows the SQUID flip-flops to operate at much faster speeds than when operated in a latching mode.

Each four-junction SQUID flip-flop 236 is a bistable logic circuit which operates in the same manner as described in connection with Figure 3A. The four possible transitions for each of the SQUID flip-flops 236, from a "0" up to a "1", from a "0" down to a "1", from a "1" up to a "0", and from a "1" down to a "0" function the same as the flip-flops 36 in Figure 3A.

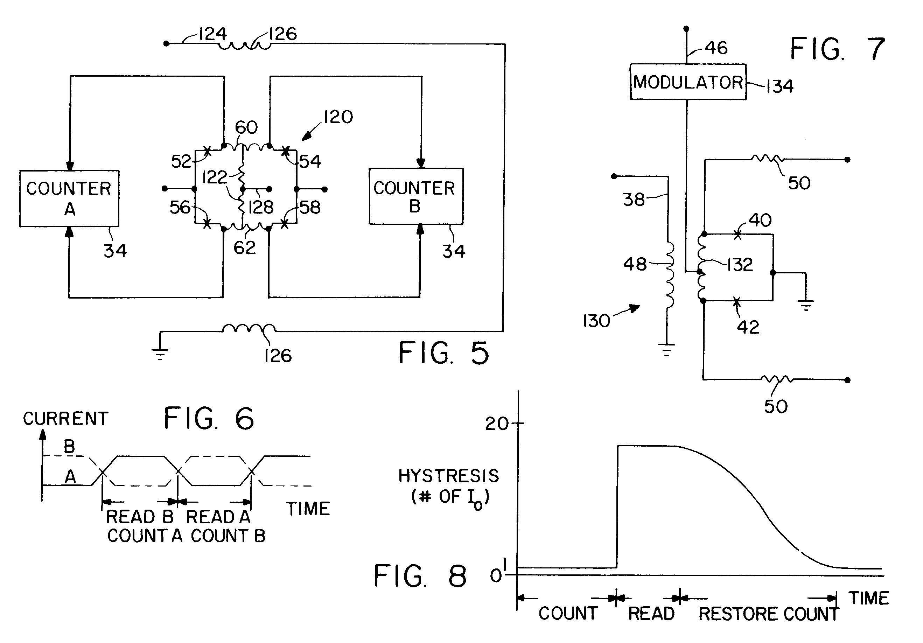

In an alternative embodiment of the high-speed, high-resolution superconducting counting A/D converter of the present invention, the quantizer is a single-junction SQUID quantizer 74, as illustrated in 35 Figure 4. The single-junction quantizer 74 generates up-count and down-count voltage pulses of the opposite polarity on a single output line for positive and negative values of an analog voltage, on line 76. In the LSB SQUID flip-flop 36 of the bidirectional binary 5 counter 34, the single output line of the quantizer 74 is applied to the center-tap terminal of inductance 60, while the center-tap terminal of inductance 62 is grounded.

The single-junction quantizer 74 includes a Josephson junction 78, an inductance 80 and a resistor 82 connected together to form a superconducting loop. One terminal of the inductance 80 is connected to a terminal of the Josephson junction 78, the other terminal of the inductance 80 is connected to a terminal of the resistor 82 and the other terminal of the resistor 82 is connected to the other terminal of the Josephson junction 78. The terminal between the Josephson junction 78 and the resistor 82 is grounded and the terminal between the inductance 80 and the resistor 82 receives the analog signal. The up-count/down-count signal is output to the binary counter from the terminal between the inductance 80 and the Josephson junction 78 and is applied to the Counter through a resistor 84.

The single-junction SQUID quantizer 74 digitizes an analog voltage, rather than an analog current, using the alternating current effect of Josephson junctions. When a voltage is applied to a Josephson junction, an alternating current is generated across the junction. Because the frequency of the current is dependent on the magnitude of the voltage, the average voltage during the sampling interval can be digitized by counting the frequency of the alternating current over that time interval.

The high-speed, high-resolution superconducting counting A/D converter of the present invention may be used with means for reading the contents of the counter at the end of each sampling interval. One technique for reading the contents of the counter is to utilize a toggling quantizer 120 and two bidirectional binary counters 34, as illustrated in Figure 5. The quantizer 120 toggles between the two counters at the end of each sampling interval so that counter A can be read while counter B is counting, and vice versa. An adder (not shown) combines the outputs of the two counters.

The toggling quantizer 120 includes the four Josephson junctions 52, 54, 56, 58 and the two inductances 60, 62 of the four-junction SQUID flip-flop 36, and first and second resistors 122. One terminal of the first resistor 122 is connected to the center-tap terminal of inductance 60, one terminal of the second resistor 122 is connected to the center-tap terminal of inductance 62 and the other terminals of the resistors 122 are connected together. An analog signal, on line 124, is transformer-coupled through windings 126 to the inductances 60, 62. A constant gate current, on line 128, is injected into the quantizer at the terminal between the two resistors 122.

Counter A is selected for counting by grounding the terminal between Josephson junctions 52, 56 and counter B is selected for counting by grounding the terminal between Josephson junctions 54, 58. The gate current flows through the two Josephson junctions having the grounded terminal, which allows the two Josephson junctions to be switched by the analog current. A diagram of the gate current flowing through the quantizer as a function of time is illustrated in Figure 6. No information can be lost during the toggling because at the crossover points, when the currents A and B are equal, one counter or the other will receive the pulses.

When counter A is selected, positive incremental changes in the analog current result in the generation of up-count voltage pulses across Josephson junction 52 and negative incremental changes result in the generation of down-count voltage pulses across Josephson junction 56. When counter B is selected, positive incremental changes in the analog current result in the generation of up-count voltage pulses across Josephson junction 54 and negative incremental changes result in the generation of down-count voltage pulses across Josephson junction 58. The up-count signal is output to counter A from the terminal between inductance 60 and Josephson junction 52 and to counter B from the terminal between inductance 60 and Josephson junction 54. The down-count signal is output to counter A from the terminal between inductance 62 and Josephson junction 56 and to counter B from the terminal between inductance 62 and Josephson junction 58.

Another technique for reading the contents of the binary counter 34 is to utilize a variable-hysteresis quantizer 130, as illustrated in Figure 7. The variable-hysteresis quantizer 130 inhibits the generation of voltage pulses during the read period, allowing the counter to be read without missing any changes in the analog signal. The variable-hysteresis quantizer 130 includes the two Josephson junctions 40, 42 of the double-junction SQUID quantizer 32 and a center-tapped inductance 132. One terminal of each of the Josephson junctions 40, 42 is connected to a different end terminal of the inductance 132 and the other terminal of each of the Josephson junctions 40, 42 is connected to ground. The constant gate current on line 46 is modulated by modulator 134, with the modulated gate current being injected into the center-tap terminal of the inductance 132. The analog signal on line 38 is transformer-coupled through winding 48 to the inductance 132.

The inductance 132 is large so that the quantizer 130 has a β_{L} >> π, where β_{L} is defined as 2πLI_{c}/F₀ and L is the inductance of the quantizer 130, I_{c} is the critical current of the Josephson junctions 40, 42 and F₀ is the flux quantum. The hysteresis of the quantizer 130 is controlled by the modulated gate current, with a small gate current producing a large hysteresis and a large gate current producing a small hysteresis.

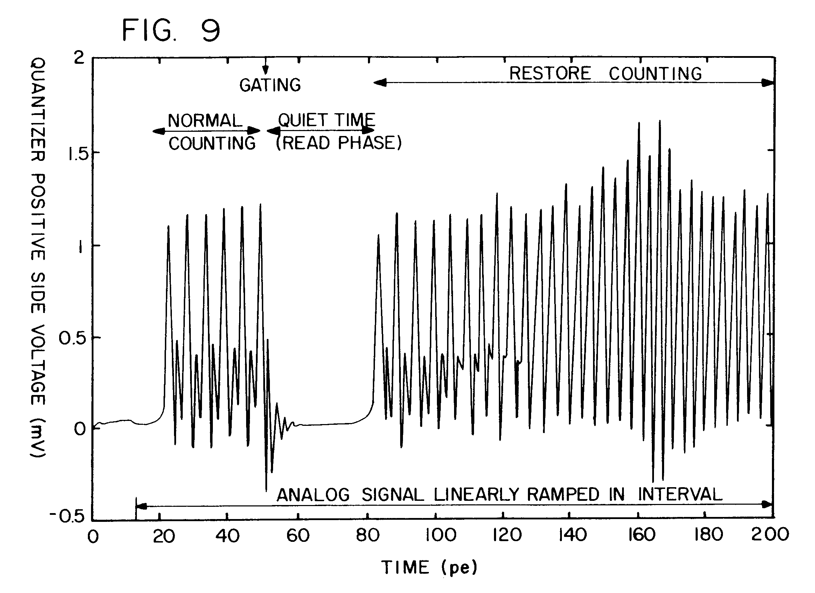

As shown in Figures 8 and 9, during the sampling interval, a small hysteresis allows the quantizer to output up-count and down-count signals to the bidirectional binary counter 34. At the end of the sampling interval, the hysteresis is rapidly increased to inhibit the generation of any additional voltage pulses. During this read period, the bits of the counter are read sequentially starting with the LSB. Any changes in the analog signal during the read period are stored in the quantizer loop as magnetic flux. The hysteresis of the quantizer is then decreased, which allows the generation of voltage pulses to be resumed. By slowly decreasing the hysteresis, the output pulse train from the quantizer is slightly compressed, as shown in Figure 9. This allows the quantizer to output new pulses and also recover the pulses that were stored in the quantizer during the read period.

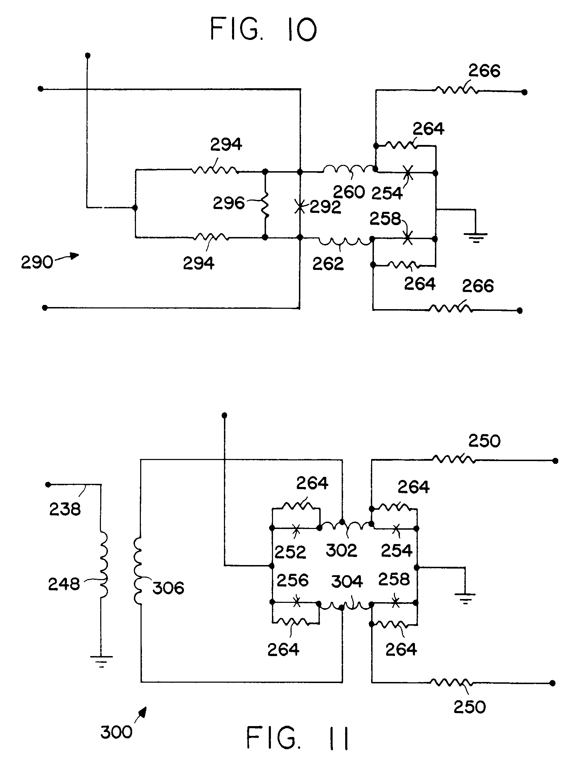

In another alternative embodiment of the high-speed superconducting counting A/D converter of the present jnvention, the SQUID flip-flops are grounded three-junction SQUID flip-flops 290, as illustrated in Figure 10. Each grounded three-junction SQUID flip-flop 290 includes the two inductances 260, 262 and the two Josephson junctions 254, 258 of the grounded four-junction SQUID flip-flop 236. The three-junction SQUID flip-flop 290 also includes a third Josephson junction 292, first and second resistors 294 and a shunt resistor 296. A terminal of the first resistor 294 is connected to the other terminal of inductance 260, a terminal of the second resistor 294 is connected to the other terminal of inductance 262 and the other terminals of the first and second resistors 294 are connected together. One terminal of the shunt resistor 296 and one terminal of Josephson junction 292 are connected to the terminal between the first resistor 294 and inductance 260 and the other terminal of the shunt resistor 296 and the other terminal of Josephson junction 292 are connected to the terminal between the second resistor 294 and inductance 262. The constant gate current is injected into the three-junction SQUID flip-flop 290 at the terminal between the first and second resistors 294.

The terminal between the first resistor 294 and inductance 260 receives the carry signal from the preceding three-junction SQUID flip-flop 290, or the up-count signal from the quantizer 232 if the three-junction SQUID flip-flop is the LSB flip-flop, and the terminal between the second resistor 294 and inductance 262 receives the down-count or borrow signal. The carry and borrow signals are output to the succeeding three-junction SQUID flip-flop 290 as in the four-junction SQUID flip-flop 236.

In the three-junction SQUID flip-flop 290, Josephson junctions 254, 258 operate as they do in the four-junction SQUID flip-flop 236 and Josephson junction 292 replaces Josephson junctions 252, 256. Josephson junction 292 performs the operations of the two Josephson junctions by pulsing either positively or negatively. Josephson junction 292 does not carry any gate current, only circulating current, and therefore the critical current of Josephson junction 292 should be about 60% less than that of the other two Josephson junctions 254, 258.

In still another alternative embodiment of the high-speed superconducting counting A/D converter of the present invention, the quantizer and the LSB four-junction SQUID flip-flop are combined to provide a four-junction SQUID quantizer 300 having an additional bit of sensitivity. As illustrated in Figure 11, the four-junction SQUID quantizer 300 includes the four Josephson junctions 252, 254, 256, 258 and the shunt resistors 264 of the grounded four-junction SQUID flip-flop 236. The four-junction SQUID quantizer 300 also includes two center-tapped inductances 302, 304 and an inductance 306. One terminal of each of the Josephson junctions 252, 254 is connected to a different end terminal of inductance 302 and one terminal of each of the Josephson junctions 256, 258 is connected to a different end terminal of inductance 304. The other terminals of Josephson junctions 252, 256 are connected together and the other terminals of Josephson junctions 254, 258 are connected together.

The A/D converter of the present invention has many advantages, including very fast A/D conversion speeds and a low device count. These advantages result from the ability of the four-junction SQUID flip-flops to control both the binary states of the stages of the counter and the bidirectional transitions and propagations of the counter. The gates that would normally process this logic cannot operate at the required speeds. Therefore, eliminating the logic gates results in an extremely fast counter which can count up or down at speeds greater than 1 count every 10 picoseconds, or a counting rate of 100 GHz. Eliminating the logic gates also reduces the device count, which greatly enhances reliability and reduces power consumption and cost.

From the foregoing, it will be appreciated that the present invention represents a significant advance in the field of superconducting analog-to-digital converters.

## Claims

1. A superconducting counting analog-to-digital converter, comprising:
a superconducting quantum interference device (SQUID) quantizer;
means for applying a varying analog signal to the SQUID quantizer;
and a bidirectional binary counter having a plurality of stages of four-junction SQUID flip-flops that are either grounded or electrically floating and are connected together in a cascade arrangement from the least significant bit (LSB) to the most significant bit (MSB);
wherein the quantizer generates up-count and down-count voltage pulses for increasing and decreasing values of the analog signal and the bidirectional binary counter algebraically counts the voltage pulses, increasing the binary count when up-count pulses are received and decreasing the binary count when down-count pulses are received.

2. The superconducting counting analog-to-digital converter as set forth in claim 1, wherein each four-junction SQUID flip-flop includes:
first, second , third and fourth Josephson junctions;
first and second center-tapped inductances; and
means for supplying a constant gate current to the four-junction SQUID flip-flops;
wherein each four-junction SQUID flip-flop is a bistable logic circuit in which the direction of the circulating current determines the state of the circuit;
and wherein an up-count pulse will ripple from flip-flop to flip-flop, changing the binary state of each stage and generating a carry pulse if the initial state of the stage is a "1", and a down-count pulse will ripple from flip-flop to flip-flop, changing the binary state of each stage and generating a borrow pulse if the initial state of the stage is a "0".

3. The superconducting counting analog-to-digital converter as set forth in claim 2, wherein one terminal of each of the first and second Josephson junctions is connected to a different end terminal of the first inductance and one terminal of each of the third and fourth Josephson junctions is connected to a different end terminal of the second inductance;
and wherein the other terminals of the first and third Josephson junctions are connected together and the other terminals of the second and fourth Josephson junctions are connected together;
and wherein the gate current is injected into each SQUID flip-flop at the terminal between the first and third Josephson junctions.

4. The superconducting counting analog-to-digital converter as set forth in claim 1 wherein the plurality of stages of four-junction SQUID flip-flops are electrically floating.

5. The superconducting counting analog-to-digital converter as set forth in claim 1 wherein the plurality of stages of four-junction SQUID flip-flops are electrically grounded.

6. The superconducting counting analog-to-digital converter as set forth in claim 2, wherein the center-tap terminal of the first inductance receives the carry pulse from the preceding four-junction SQUID flip-flop, or the up-count pulse from the quantizer if the four-junction SQUID flip-flop is the LSB flip-flop, and the center-tap terminal of the second inductance receives the borrow pulse from the preceding four-junction SQUID flip-flop, or the down-count pulse from the quantizer if the four-junction SQUID flip-flop is the LSB flip-flop;
and wherein the carry pulse is output to the succeeding four-junction SQUID flip-flop from the terminal between the first inductance and the second Josephson junction and the borrow pulse is output to the borrow pulse is output to the succeeding four-junction SQUID flip-flop from the terminal between the second inductance and the fourth Josephson junction.

7. The superconducting counting analog-to-digital converter as set forth in claim 2, wherein when a four-junction SQUID flip-flop is indicating a "0", an up-count or carry pulse causes the third Josephson junction to pulse and a down-count or borrow pulse causes the fourth Josephson junction to pulse and output a borrow pulse to the succeeding SQUID flip-flop;
and wherein when a SQUID flip-flop is indicating a "1", an up-count or carry pulse causes the second Josephson junction to pulse and output a carry pulse to the succeeding SQUID flip-flop and a down-count or borrow pulse causes the first Josephson junction to pulse.

8. The superconducting counting analog-to-digital converter as set forth in claim 2, and further including shunt resistors connected across the terminals of each Josephson junction, whereby each four-junction SQUID flip-flop operates in a nonlatching mode.

9. The superconducting counting analog-to-digital converter as set forth in claim 2, and further including means for inducing a flux bias current in each SQUID flip-flop.

10. The superconducting counting analog-to-digital converter as set forth in claim 1, wherein the quantizer is a double-junction SQUID quantizer including:
first and second Josephson junctions;
a center-tapped inductance; and
means for supplying a constant gate current to the center-tap terminal of the inductance;
wherein positive incremental changes in the analog current result in the generation of up-count voltage pulses across the first Josephson junction and negative incremental changes in the analog current result in the generation of down-count voltage pulses of the same polarity across the second Josephson junction.

11. The superconducting counting analog-to-digital converter as set forth in claim 1, wherein the quantizer is a single-junction SQUID quantizer; including:
a Josephson junction; and
an inductance;
wherein a positive analog voltage results in the generation of up-count voltage pulses across the Josephson junction and a negative analog voltage results in the generation of down-count voltage pulses of the opposite polarity across the Josephson junction.

12. A superconducting bidirectional binary counter for counting up-count and down-count voltage pulses, comprising:
a plurality of stages of grounded or electrically floating four-junction superconducting quantum interference device (SQUID) flip-flops connected together in a cascade arrangement from the least significant bit (LSB) to the most significant bit (MSB);
wherein the bidirectional binary counter algebraically counts the up-count and down-count voltage pulses, increasing the binary count when up-count pulses are received and decreasing the binary count when down-count pulses are received.

13. The superconducting bidirectional counter as set forth in claim 12, wherein each floating four-junction SQUID flip-flop includes:
first, second, third and fourth Josephson junctions;
first and second center-tapped inductances; and
means for supplying a constant ungrounded gate current to the four-junction SQUID flip-flops;
wherein each four-junction SQUID flip-flop is a bistable logic circuit in which the direction of the circulating current determines the state of the circuit;
and wherein an up-count pulse will ripple from flip-flop to flip-flop, changing the binary state of each stage and generating and carry pulse if the initial state of the stage is a "1", and a down-count pulse will ripple from flip-flop to flip-flop, changing the binary state of each stage and generating a borrow pulse if the initial state of the stage is a "0".

## Patentansprüche

1. Supraleitender zählender Analog-zu-Digital-Konverter, der folgendes umfaßt:
- einen supraleitenden Quanteninterferometer-(SQUID-) Quantisierer;
- eine Einrichtung zum Anlegen eines variierenden analogen Signals an den SQUID-Quantisierer; und
- einen bidirektionalen Binärzähler mit einer Vielzahl von Stufen aus Vier-Übergang-SQUID-Flipflops, die entweder geerdet oder elektrisch potentialfrei sind und miteinander vom niedrigstwertigen Bit (LSB) zum höchstwertigen Bit (MSB) in einer Kaskadenanordnung verbunden sind;
worin der Quantisierer für ansteigende und abfallende Werte des analogen Signals Vorwärtszähl- und Rück-wärtszähl-Spannungsimpulse erzeugt und der bidirektionale Binärzähler die Spannungsimpulse algebraisch zählt, den binären Zählerstand erhöht, wenn Vorwärtszählimpulse empfangen werden und den binären Zählerstand erniedrigt, wenn Rückwärtszählimpulse empfangen werden.

2. Supraleitender zählender Analog-zu-Digital-Konverter wie in Anspruch 1 beschrieben, worin jedes Vier-Übergang-SQUID-Flipflop folgendes beinhaltet:
- erste, zweite, dritte und vierte Josephson-Kontakte;
- erste und zweite mittig abgegriffene Induktivitäten;
- eine Einrichtung zum Einspeisen eines konstanten Gatestroms in die Vier-Übergang-SQUID-Flipflops; worin jedes Vier-Übergang-SQUID-Flipflop eine bistabile Logikschaltung ist, bei der die Richtung des kreisenden Stroms den Zustand der Schaltung bestimmt; und worin ein Vorwärtszählimpuls von Flipflop zu Flipflop läuft, den binären Zustand jeder Stufe verändert und einen Übertragimpuls erzeugt, falls der Anfangszustand der Stufe eine "1" ist und ein Rückwärtszählimpuls von Flipflop zu Flipflop läuft, den binären Zustand jeder Stufe verändert und einen Borgeimpuls erzeugt, falls der Anfangszustand der Stufe eine "0" ist.

3. Supraleitender zählender Analog-zu-Digital-Konverter wie in Anspruch 2 beschrieben, worin ein Anschluß jedes der ersten und zweiten Josephson-Kontakte mit einem anderen Endanschluß der ersten Induktivität verbunden ist und ein Anschluß jedes der dritten und vierten Josephson-Kontakte mit einem anderen Endanschluß der zweiten Induktivität verbunden ist; und worin die anderen Anschlüsse des ersten und dritten Josephson-Kontakts miteinander verbunden sind und die anderen Anschlüsse des zweiten und vierten Josephson-Kontakts miteinander verbunden sind; und
worin der Gatestrom am Anschluß zwischen dem ersten und dritten Josephson-Kontakt in jedes SQUID-Flipflop injiziert wird.

4. Supraleitender zählender Analog-zu-Digital-Konverter wie in Anspruch 1 beschrieben, worin die Vielzahl von Stufen von Vier-Übergang-SQUID-Flipflops elektrisch potentialfrei sind.

5. Supraleitender zählender Analog-zu-Digital-Konverter wie in Anspruch 1 beschrieben, worin die Vielzahl von Stufen der Vier-Übergang-SQUID-Flipflops elektrisch geerdet sind.

6. Supraleitender zählender Analog-zu-Digital-Konverter wie in Anspruch 2 beschrieben, worin der mittige Abgriffanschluß der ersten Induktivität den Übertragimpuls vom vorhergehenden Vier-Übergang-SQUID-Flipflop oder, falls das Vier-Übergang-SQUID-Flipflop das LSB-Flipflop ist, den Vorwärtszählimpuls vom Quantisierer empfängt und der mittige Abgriffanschluß der zweiten Induktivität den Borgeimpuls vom vorhergehenden Vier-Übergang-SQUID-Flipflop oder, falls das Vier-Übergang-SQUID-Flipflop das LSB-Flipflop ist, den Rückwärtszählimpuls vom Quantisierer empfängt; und
worin der Übertragimpuls vom Anschluß zwischen der ersten Induktivität und dem zweiten Josephson-Kontakt an das nachfolgende Vier-Übergang-SQUID-Flipflop ausgegeben wird und der Borgeimpuls vom Anschluß zwischen der zweiten Induktivität und dem vierten Josephson-Kontakt an das nachfolgende Vier-Übergang-SQUID-Flipflop ausgegeben wird.

7. Supraleitender zählender Analog-zu-Digital-Konverter wie in Anspruch 2 beschrieben, worin, wenn ein Vier-Übergang-SQUID-Flipflop eine "0" anzeigt, ein Vor-wärtszähl- oder Übertragimpuls bewirkt, daß der dritte Josephson-Kontakt pulsiert und ein Rückwärtszähl- oder Borgeimpuls bewirkt, daß der vierte Josephson-Kontakt pulsiert und einen Borgeimpuls an das nachfolgende SQUID-Flipflop ausgibt; und
worin, wenn ein SQUID-Flipflop eine "1" anzeigt, ein Vorwärtszähl- oder Übertragimpuls bewirkt, daß der zweite Josephson-Kontakt pulsiert und einen Übertragimpuls an das nachfolgende SQUID-Flipflop ausgibt und ein Rückwärtszähl- oder Borgeimpuls bewirkt, daß der erste Josephson-Kontakt pulsiert.

8. Supraleitender zählender Analog-zu-Digital-Konverter wie in Anspruch 2 beschrieben, der desweiteren mit den Anschlüssen jedes Josephson-Kontakts verbundene Shuntwiderstände beinhaltet, wodurch jedes Vier-Übergang-SQUID-Flipflop in einem nichtsperrenden Modus arbeitet.

9. Supraleitender zählender Analog-zu-Digital-Konverter wie in Anspruch 2 beschrieben, der desweiteren.eine Einrichtung zum Induzieren eines Fluß-Vormagnetisierungsstroms in jedem SQUID-Flipflop beinhaltet.

10. Supraleitender zählender Analog-zu-Digital-Konverter wie in Anspruch 1 beschrieben, worin der Quantisierer ein Doppel-Übergang-SQUID-Quantisierer ist, der folgendes beinhaltet:
- erste und zweite Josephson-Kontakte;
- eine Induktivität mit mittigem Abgriff; und
- eine Einrichtung zum Einspeisen eines konstanten Gatestroms in den mittigen Abgriffanschluß der Induktivität;
worin positive Zuwachsänderungen des analogen Stroms zur Erzeugung von Vorwärtszähl-Spannungsimpulsen am ersten Josephson-Kontakt führen und negative Zuwachsänderungen des analogen Stroms zur Erzeugung von Rückwärtszähl-Spannungsimpulsen derselben Polarität am zweiten Josephson-Kontakt führen.

11. Supraleitender zählender Analog-zu-Digital-Konverter wie in Anspruch 1 beschrieben, worin der Quantisierer ein Ein-Übergang-SQUID-Quantisierer ist, der folgendes beinhaltet:
- einen Josephson-Kontakt; und
- eine Induktivität;
worin eine positive analoge Spannung zur Erzeugung von Vorwärtszähl-Spannungsimpulsen am Josephson-Kontakt führt und eine negative analoge Spannung zur Erzeugung von Rückwärtszähl-Spannungsimpulsen der entgegengesetzten Polarität am Josephson-Kontakt führt.

12. Supraleitender bidirektionaler Binärzähler zum Zählen von Vorwärtszähl- und Rückwärtszähl-Spannungsimpulsen, der folgendes umfaßt:
eine Vielzahl von Stufen geerdeter oder elektrisch potentialfreier supraleitender Vier-Übergang-Quanteninterferometer-(SQUID-)Flipflops, die miteinander vom niedrigstwertigen Bit (LSB) zum höchstwertigen Bit (MSB) in einer Kaskadenanordnung verbunden sind; worin der bidirektionale Binärzähler die Vorwärtszähl- und Rückwärtszähl-Spannungsimpulse algebraisch zählt, den binären Zählerstand erhöht, wenn Vorwärtszählimpulse empfangen werden und den binären Zählerstand erniedrigt, wenn Rückwärtszählimpulse empfangen werden.

13. Supraleitender bidirektionaler Zähler wie in Anspruch 12 beschrieben, worin jedes potentialfreie Vier-Übergang-SQUID-Flipflop folgendes beinhaltet:
- erste; zweite, dritte und vierte Josephson-Kontakte;
- erste und zweite Induktivitäten mit mittigem Abgriff; und
- eine Einrichtung zum Einspeisen eines konstanten ungeerdeten Gatestroms in die Vier-Übergang-SQUID-Flipflops;
worin jedes Vier-Übergang-SQUID-Flipflop eine bistabile Logikschaltung ist, bei der die Richtung des kreisenden Stroms den Zustand der Schaltung bestimmt; und
worin ein Vorwärtszählimpuls von Flipflop zu Flipflop läuft, den binären Zustand jeder Stufe verändert und einen Übertragimpuls erzeugt, falls der Anfangszustand der Stufe eine "1" ist, und ein Rückwärtszählimpuls von Flipflop zu Flipflop läuft, den binären Zustand jeder Stufe verändert und einen Borgeimpuls erzeugt, falls der Anfangszustand der Stufe eine "0" ist.

## Revendications

1. Convertisseur supraconducteur de comptage analogique-numérique comprenant :
un quantificateur à interféromètre quantique supraconducteur (SQUID) ;
des moyens pour appliquer un signal analogique variable au quantificateur SQUID ;
et un compteur binaire bidirectionnel comportant plusieurs étages de circuits bistables SQUID quatre jonctions qui sont, soit mis à la terre, soit électroflottantes et sont connectés en un montage en cascade à partir de l'élément binaire de poids faible (LSB) vers l'élément binaire de poids fort (MSB) ;
dans lequel le quantificateur produit des impulsions de tension de comptage croissant et décroissant pour augmenter ou diminuer les valeurs du signal analogique, et le compteur binaire bidirectionnel compte algébriquement les impulsions de tension, augmentant le comptage binaire à la réception d'impulsions de comptage croissant et réduisant le comptage binaire à la réception d'impulsions de comptage décroissant.

2. Compteur supraconducteur de comptage analogique-numérique tel que défini dans la revendication 1, dans lequel chaque circuit bistable SQUID à quatre jonctions comprend :
des première, seconde, troisième et quatrième jonctions Josephson ;
des première et seconde inductances à prise médiane ;
des moyens pour fournir un courant de grille ou de gâchette constant aux circuits bistables SQUID à quatre jonctions ;
dans lequel chaque circuit bistable SQUID à quatre jonctions est un circuit logique bistable dans lequel la direction du courant en circulation détermine l'état du circuit ;
et dans lequel une impulsion de comptage croissant est générée en ondulation d'un circuit bistable vers un autre circuit bistable, modifiant l'état binaire de chaque étage et produisant une impulsion porteuse si l'état initial de l'étage est un "1", et une impulsion de comptage décroissant est produite en ondulation d'un circuit bistable vers un autre circuit bistable, modifiant l'état binaire de chaque étage et produisant une impulsion de retenue négative si l'état initial de l'étage est un "0".

3. Convertisseur supraconducteur de comptage analogique-numérique tel que défini dans la revendication 2, dans lequel une borne de chacune des première et seconde jonctions Josephson est connectée à une borne d'extrémité différente de la première inductance, et une borne de chacune des troisième et quatrième jonctions Josephson est connectée à une borne d'extrémité différente de la seconde inductance ;
et dans lequel les autres bornes des première et troisième jonctions Josephson sont connectées ensemble et les autres bornes des seconde et quatrième jonctions Josephson sont connectées ensemble ;
et dans lequel le courant de grille ou de gâchette est injecté dans chaque circuit bistable SQUID au niveau de la borne entre les première et troisième jonctions Josephson.

4. Convertisseur supraconducteur de comptage analogique-numérique tel que défini dans la revendication 1, dans lequel plusieurs étages de quatre circuits bistables SQUID sont électroflottants.

5. Convertisseur supraconducteur de comptage analogique-numérique tel que défini dans la revendication 1, dans lequel les différents étages des circuits bistables SQUID à quatre jonctions sont électriquement mis à la terre.

6. Convertisseur supraconducteur de comptage analogique-numérique tel que défini dans la revendication 2, dans lequel la borne de prise centrale de la première inductance reçoit l'impulsion porteuse en provenance du circuit bistable SQUID précédent à quatre jonctions, ou l'impulsion de comptage croissant à partir du quantificateur si le circuit bistable SQUID à quatre jonctions est le circuit bistable LSB, et la borne centrale de la seconde inductance reçoit l'impulsion d'emprunt ou impulsion de retenue négative provenant du circuit bistable SQUID à quatre jonctions précédent, ou l'impulsion de comptage décroissant à partir du quantificateur si le circuit bistable SQUID à quatre jonctions est le circuit bistable LSB ;
et dans lequel l'impulsion porteuse est émise au circuit bistable SQUID à quatre jonctions suivant en provenance de la borne entre la première inductance et la seconde jonction Josephson et l'impulsion de retenue négative est émise au circuit bistable SQUID à quatre jonctions suivant à partir de la borne entre la seconde inductance et la quatrième jonction Josephson.

7. Convertisseur supraconducteur de comptage analogique-numérique tel que défini dans la revendication 2, dans lequel lorsqu'un circuit bistable SQUID à quatre jonctions indique un "0", un comptage croissant ou une impulsion porteuse entraîne la mise en impulsion de la troisième jonction Josephson et un comptage décroissant ou une impulsion de retenue négative provoque la mise en impulsion de la quatrième jonction Josephson et l'émission d'une impulsion de retenue négative au circuit bistable SQUID suivant ;
et dans lequel lorsqu'un circuit bistable SQUID indique un "1", un comptage croissant ou une impulsion porteuse entraîne la mise en impulsion de la seconde jonction Josephson et l'émission d'une impulsion porteuse au circuit bistable SQUID suivant et une impulsion de comptage décroissant ou une impulsion porteuse entraîne la mise en impulsion de la première jonction Josephson.

8. Convertisseur supraconducteur de comptage analogique-numérique tel que défini dans la revendication 2, comprenant, de plus, des résisteurs ou résistances de dérivation connectés aux bornes de chaque jonction Josephson, chaque circuit bistable SQUID à quatre jonctions fonctionnant alors dans un mode de non verrouillage.

9. Convertisseur supraconducteur de comptage analogique-numérique tel que défini dans la revendication 2, comprenant de plus des moyens pour induire un courant de polarisation de flux dans chaque circuit bistable SQUID.

10. Convertisseur supraconducteur de comptage analogique-numérique tel que défini dans la revendication 1, dans lequel le quantificateur est un quantificateur SQUID à double jonction comprenant :
des première et seconde jonctions Josephson ;
une inductance à prise médiane ou à borne centrale ; et
des moyens pour fournir un courant de grille ou de gâchette constant à la borne de prise médiane de l'inductance ;
dans laquelle les modifications incrémentales positives dans le courant analogique entraînent la production d'impulsions de tension de comptage croissant au niveau de la première jonction Josephson, et des modifications incrémentales négatives dans le courant analogique entraînent la production d'impulsions de tension de comptage décroissant de la même polarité au niveau de la seconde jonction Josephson.

11. Convertisseur supraconducteur de comptage analogique-numérique tel que défini dans la revendication 1, dans lequel le quantificateur est un quantificateur SQUID à jonction unique comprenant :
une jonction Josephson ; et
une inductance ;
dans laquelle une tension analogique positive entraîne la production d'impulsions de tension de comptage croissant au niveau de la jonction Josephson et une tension analogique négative entraîne la production d'impulsions de tension de comptage décroissant de polarité opposée au niveau de la jonction Josephson.

12. Compteur supraconducteur bidirectionnel binaire pour le comptage d'impulsions de tension de comptage croissant et de comptage décroissant comprenant :
plusieurs étages de circuits bistables SQUID interféromètres quantiques supraconducteurs à quatre jonctions mis à la terre ou électro-flottants connectés ensemble en montage en cascade à partir de l'élément binaire de poids faible (LSB) jusqu'à l'élément binaire de poids fort (MSB) ;
dans lequel le compteur binaire bidirectionnel compte algébriquement les impulsions de tension de comptage croissant et de comptage décroissant, augmentant le comptage binaire à la réception d'impulsions de comptage croissant et diminuant le comptage binaire à la réception d'impulsions de comptage décroissant.

13. Compteur supraconducteur bidirectionnel tel que défini dans la revendication 12, dans lequel chaque circuit bistable SQUID à quatre jonctions électroflottantes comprend :
des première, seconde, troisième et quatrième jonctions Josephson ;
des première et seconde inductances à prise médiane ; et
des moyens pour fournir un courant de grille ou de gâchette constant non mis à la terre aux circuits bistables SQUID à quatre jonctions ;
dans lequel chaque élément bistable SQUID à quatre jonctions est un circuit logique bistable dans lequel la direction du courant en circulation détermine l'état du circuit ;
et dans lequel une impulsion de comptage croissant est produite en ondulation à partir d'un circuit bistable vers un autre circuit bistable, modifiant l'état binaire de chaque étage et produisant une impulsion porteuse si l'état initial de l'étage est "1" et une impulsion de comptage décroissant est produite en ondulation à partir d'un circuit bistable vers un autre circuit bistable, modifiant l'état binaire de chaque étage et produisant une impulsion de retenue négative si l'état initial de l'étage est un "0".
